Europäisches Patentamt

European Patent Office

Office européen des brevets

(11) Publication number: **0 106 637**
**B1**

(12) **EUROPEAN PATENT SPECIFICATION**

(45) Date of publication of patent specification: **17.02.88**

(21) Application number: **83306057.7**

(22) Date of filing: **06.10.83**

(51) Int. Cl.⁴: **C 23 C 16/32,** C 23 C 16/02, G 02 B 1/10, G 02 B 1/12

(54) Infra red transparent optical components.

(30) Priority: **12.10.82 GB 8229124**

(43) Date of publication of application: **25.04.84 Bulletin 84/17**

(45) Publication of the grant of the patent: **17.02.88 Bulletin 88/07**

(84) Designated Contracting States: **CH DE FR LI NL**

(56) References cited:
EP-A-0 030 638
GB-A-1 560 110
GB-A-2 047 877
GB-A-2 067 304
GB-A-2 069 008
GB-A-2 081 695
GB-A-2 082 562
GB-A-2 083 841
US-A-3 424 661
US-A-4 127 659
PATENT ABSTRACTS OF JAPAN, unexamined applications, C section, vo.3, no.19, February 17, 1979; THE PATENT OFFICE JAPANESE GOVERNMENT, page 142 C 37

(73) Proprietor: **NATIONAL RESEARCH DEVELOPMENT CORPORATION**
**101 Newington Causeway**
**London SE1 6BU (GB)**

(72) Inventor: **Green, Geoffrey William**
**5 Piers Close Malvern**
**Worcestershire (GB)**
Inventor: **Lettington, Alan Harold**
**86 Arundel Drive**
**Battenhall Worcester WR5 2NA (GB)**

(74) Representative: **Edwards, John Brian**
**Procurement Executive Ministry of Defence**
**Patents 1 A (4), Room 2014 Empress State Building Lillie Road**
**London SW6 1TR (GB)**

(56) References cited:
**PATENT ABSTRACTS OF JAPAN, unexamined applications, C field, vol.6, no.261, December 21, 1982; THE PATENT OFFICE JAPANESE GOVERNMENT, page 150C141**

Courier Press, Leamington Spa, England.

## Description

The invention concerns an optical component having a hard infra red transparent coating. The component may be a lens or window.

Optical components have been previously coated with a layer of hard carbon deposited in a hydrocarbon plasma. These coatings are useful on for example germanium lenses used in infra red thermal imagers since the carbon coatings are very hard, wear-resistant and substantially transparent to infra-red radiation. Both silicon and germanium are transparent to infra red and are useful in various infra red equipments.

There are a number of techniques for coating substrates. For example a substrate may be suspended above a cathode target of the coating material in a vacuum. Argon ions are caused to strike the target thereby knocking off small particles of the target material which adhere to the substrate. Such a technique is known as sputtering. Carbon can be sputtered but the deposition rate is low and the coating may be graphitic.

Coatings may be grown in a plasma. For example a substrate may be used as a cathode in a D.C. or A.C. excited hydrocarbon plasma. Carbon ions are attracted to strike the substrate and form a carbon layer which for appropriate temperature and pressure conditions, is diamond-like.

Techniques for growing carbon films are described in the following articles and their associated references:-

Thin Solid Films 58 (1979) 101—105, 106, 107—116, 117—120; Patent Specifications Nos. G.B. 2,047,877 A, 2,067,304 A, 2,069,008 A, 2,082,562 A, 2,083,841 A.

Techniques for growing amorphous layers of silicon and germanium by glow discharge are described in the following article and its associated references:-

Spear W. E., Doped Amorphous Semiconductor, Advances in Physics 1977 Vol 26, No. 6, 811—845.

A disadvantage with the prior art glow discharge deposition is that in order to achieve reasonable deposition rates high potentials have to be applied or developed at the cathode, so that the substrate is subjected to high energy incident particles. This tends to affect the stress in the coating and increases the back sputtering rate. In some cases this prevents deposition of a layer at all. A process for growing silicon compounds using reactive plasma techniques is described in US 3 424 661.

The disadvantage of the prior art infra red transparent carbon coatings are overcome by this invention which involves incorporating an amount of germanium or silicon in a carbon coating.

According to this invention an optical component comprises an infra red transparent lens or window having a coating on at least one surface characterised in that the coating is at least one layer of $Ge_xC_{1-x}$ or $Si_xC_{1-x}$ where $0 < x < 1$, the value of x varying across the thickness of the coating with x approaching the value 1 on the interface side of the coating to the substrate and with x approaching the value zero on the surface of the coating, said layer being substantially infra red transparent substantially hydrogen and strain free.

Small amounts of Ge, Si give a hard carbon coating that is relatively strain free due to the inclusion of Ge, Si. Thus quite thick strain free layers may be grown. Also the high temperature of growth results in little if any $H_2$ within the layer. This results in a coating which absords little infra red ight. In contrast hard carbon layers grown by the prior art methods contain hydrogen and interstitial carbon which gives rise to black absorbing layers and highly strained layers.

One method of depositing coatings containing carbon and another element comprises the steps of providing a plasma containing the materials to be deposited as a coating in a chamber having a cathode structure, arranging a substrate to be coated on the cathode, and maintaining the substrate at an elevated temperature during growth.

The elevated temperature is high enough, above about 400°C, to drive out the required amount of hydrogen. A typical temperature is about 530°C although most hydrogen is driven out below this e.g. at about 500°C.

Apparatus for depositing a coating on a substrate comprises a vacuum tight chamber, a pump for maintaining a vacuum within the chamber, means for supplying a mixture of at least two gases into the chamber, an anode and a cathode structure within the chamber, a cathode heater, a power supply for providing a glow discharge in the chamber adjacent the cathode, the arrangement being such that a plasma of at least two gaseous materials is established in the chamber so that ions of the material deposit on the substrate arranged on the cathode to form a coating.

Alternatively one of the gas supplies may be replaced by a molecular beam oven or an ion beam source etc. to provide one of the materials in the plasma. This oven or source may be mounted in the chamber and direct its contents into the region around the cathode.

The glow discharge may be provided by D.C. or A.C. or any suitable frequency.

The invention will now be described by way of example only.

Apparatus for producing a coated optical component comprises a vacuum tight container fromed by an annular wall and earthed top and bottom plates. A pump is connected through an exhaust pipe and valve to the chamber. Gas supplies of argon, germane and a hydrocarbon gas such as butane are fed into the chamber via inlet pipes and valves. A cathode structure is supported inside the chamber and electrically insulated from the bottom plate by a sleeve. Inside the cathode structure is a heater for heating a substrate arranged on the cathode. Cathode temperature is controlled by a heater control which also supplies power to the heater. A power supply feeds electrical power to the cathode. This power may be DC or AC via a blocking capacitor. Alternatively an AC coil may surround the chamber and induce a plasma within the chamber.

A germanium lens may be coated with a layer of hard carbon as follows. The lens is mounted on the cathode with the surface to be coated uppermost. The chamber is evacuated by the pump to less than $1.3 \times 10^{-5}$ millibar ($10^{-5}$ Torr) to remove contaminants. Argon gas is admitted through the valve and the chamber pressure kept at about $1.3 \times 10^{-2}$ millibar ($10^{-2}$ Torr) on an air calibrated gauge.

A plasma is generated in argon by energising the cathode from the power supply. This provides an argon ion bombardment of the surface to clean it prior to coating. About 2 minutes cleaning is usually adequate.

The cathode heater is operated to raise the lens temperature to above about 500° typically 530° and maintain it at this value during growth of the coating.

The argon is removed by the pump and a mixture of germane ($GeH_4$) and butane ($C_yH_{10}$) admitted via the inlet pipe and valves. Pressure is maintained at around 0.9 to $1.10^{-2}$ millibar (0.7 to $1.10^{-2}$ Torr). AC power of typically 1 kvolt at 13 MHz and 200 watts power level is applied to create a plasma. Positively charged ions of C, and of Ge strike and remain on the lens surface gradually building up a layer of hard carbon with small amounts of Ge included.

The layer thickness is time and composition dependent and is selected for optical properties (anti-reflection) and required durability. Typical layer thickness is 1 to 10 μm. The discharge is stopped when the required thickness is grown and the substrate allowed to cool.

To assist in growing a uniform layer the substrate may be rotated during growth.

### Claims

1. An optical component comprising an infra red transparent lens or window having a coating on at least one surface characterised in that the coating is at least one layer of $Ge_xC_{1-x}$ or $Si_xC_{1-x}$ where $0 < x < 1$, the value of x varying across the thickness of the coating with x approaching the value 1 on the interface side of the coating to the substrate and with x approaching the value zero on the surface of the coating said layer being substantially infra red transparent substantially hydrogen and strain free.

2. The coating of claim 1 wherein the lens of window is of Ge, S1, ZnS, ZnSe material.

3. The component of claim 1 wherein a bonding layer is formed on the lens or window under the coating.

4. The component of claim 1 wherein the value of x and thickness t of the coating, where t is between 1 μm and 10 μm, is arranged to give an anti-reflection coating.

### Patentansprüche

1. Optische Komponente mit einer infrarotdurchlässigen Linse oder einem infrarotdurchlässigen Fenster, die bzw. das auf minstestens einer Oberfläche mit einem Überzug versehen ist, dadurch gekennzeichnet, daß der Überzug aus mindestens einer Schicht aus $Ge_xC_{1-x}$ oder $Si_xC_{1-x}$ besteht, wobei $0 < x < 1$, wobei weiter der Wert von x sich über die Dicke des Überzugs verändert und x an der Grenzfläche des Überzugs zum Substrat sich dem Wert 1 annähert und an der Oberfläche des Überzugs dem Wert 0 annähert, und wobei die Schicht im wesentlichen infrarotdurchlässig sowie im wesentlichen wasserfrei und spannungsfrei ist.

2. Komponente nach Anspruch 1, wobei die Linse bzw. das Fenster aus Ge, Si, ZnS, ZnSe-Material besteht.

3. Komponente nach Anspruch 1, wobei eine Bindeschicht unter dem Überzug auf der Linse bzw. dem Fenster gebildet ist.

4. Komponente nach Anspruch 1, wobei der Wert von x und die Dicke t des Überzugs, welch letztere zwischen 1 μm und 10 μm liegt, so gewählt sind, daß sich ein reflexionsarmer Überzug ergibt.

### Revendications

1. Composant optique comprenant une lentille ou fenêtre, transparente à l'infrarouge, comportant un revêtement sur au moins une surface, composant caractérisé en ce que le revêtement est constitué par au moins une couche de $Ge_xC_{1-x}$ ou $Si_xC_{-x}$, où $0 < x < 1$, la valeur de x variant dans toute l'épaisseur du revêtement, x se rapprochant de la valeur 1 du coté de l'interface du revêtement avec le substrat et x se rapprochant de la veleur 0 à la surface de revêtement, ladite couche étant essentiellement transparante à l'infrarouge et essentiellement dépourvue d'hydrogéne et de contraintes.

2. Composant selon la revendication 1, dans laquelle la matiére de la lentille ou de la fenêtre est en, ou à base de, Ge, Si, ZnS, ZnSe.

3. Composant selon la revendication 1, dans lequel une couche de liaison est formée sur la lentille ou la fenêtre sous le revêtement.

4. Composant selon la revendication 1, dans lequel la valeur de x et l'épaisseur t du revêtement cette épaisseur t se situant entre 1 μm et 10 μm, sont telles que l'on obtient un revêtement anti-réflexion ou anti-reflet.